# EUROPEAN PATENT APPLICATION

(11) **EP 1 965 453 A2**
(43) Date of publication of application: **03.09.2008**
(21) Application number: 08151843.3
(22) Date of filing: 22.02.2008
(51) Int. Cl.: H01L 51/52

(54) **Hermetic sealing using tin-containing inorganic material with low sintering temperature**

(30) Priority: 28.02.2007 US 903983 P
(71) Applicant: CORNING INC., Corning NY 14831 (US)
(72) Inventor: Aitken, Bruce, Corning, NY 14830 (US); Quesada, Mark, Horseheads, NY 14845 (US)
(74) Representative: Marchant, James Ian

(57) **Abstract**

A method for inhibiting oxygen and moisture degradation of a device (e.g., an OLED device) and the resulting device are described herein. To inhibit the oxygen and moisture degradation of the device, a Sn²⁺-containing inorganic material is used to form a barrier layer on the device. The Sn²⁺-containing inorganic material can be, for example, SnO, blended SnO & P₂O₅ powders, and blended SnO & BPO₄ powders.

## Description

### TECHNICAL FIELD

The present invention relates to a method for using a Sn²⁺-containing inorganic material as a thin barrier layer to inhibit oxygen and moisture penetration into a device and the resulting device. Examples of the device include a light-emitting device (e.g., organic emitting light diode (OLED) device), a photovoltaic device, a thin-film sensor, an evanescent waveguide sensor, a food container and a medicine container.

### BACKGROUND

Transport of oxygen and/or water through laminated or encapsulated materials and subsequent attack of an inner material within a device represents two of the more common degradation mechanisms associated with many devices including for example light-emitting devices (OLED devices), thin-film sensors, evanescent waveguide sensors, food containers and medicine containers. For a detailed discussion about the problems associated with oxygen and water penetration into the inner layers (cathode and electro-luminescent materials) of an OLED and other devices, reference is made to the following documents:
- Aziz, H., Popovic, Z. D., Hu, N. X., Hor, A. H., and Xu, G. "Degradation Mechanism of Small Molecule-Based Organic Light-Emitting Devices", Science, 283, pp. 1900 - 1902, (1999).
- Burrows, P. E., Bulovic., V., Forrest, S. R., Sapochak, L. S., McCarty, D. M., Thompson, M. E. "Reliability and Degradation of Organic Light Emitting Devices", Applied Physics Letters, 65(23), pp. 2922 - 2924.
- Kolosov, D., et al., Direct observation of structural changes in organic light emitting devices during degradation. Journal of Applied Physics, 2001. 90(7).
- Liew, F.Y., et al., Investigation of the sites of dark spots in organic light-emitting devices. Applied Physics Letters, 2000. 77(17).
- Chatham, H., "Review: Oxygen Diffusion Barrier Properties of Transparent Oxide Coatings on Polymeric Substrates", 78, pp. 1 - 9, (1996).

It is well known that unless something is done to minimize the penetration of oxygen and water into an OLED device, then their operating lifetimes will be severely limited. As a result, much effort has been expended to minimize the penetration of oxygen and water into an OLED device to help drive OLED operation towards a 40 kilo-hour lifetime, the levels generally regarded as necessary so that OLED devices can overtake older device technologies such as LCD displays as discussed in the following document:
- Forsythe, Eric, W., "Operation of Organic-Based Light-Emitting Devices, in Society for Information Device (SID) 40th anniversary Seminar Lecture Notes, Vol. 1, Seminar M5, Hynes Convention Center, Boston, MA, May 20 and 24, (2002).

The more prominent efforts that have been performed to date to help extend the lifetime of OLED devices include gettering, encapsulating and using various sealing techniques. In fact, one common way for sealing an OLED device today is to apply and heat-treat (or UV treat) different types of epoxies, inorganic materials and/or organic materials to form a seal on the OLED device. For example, Vitex Systems manufactures and sells a coating under the brand name of Barix^{™} which is a composite based approach where alternate layers of inorganic materials and organic materials are used to seal the OLED device. Although these types of seals provide some level of hermetic behavior, they can be very expensive and there are still many instances in which they have failed over time to prevent the diffusion of oxygen and water into the OLED device.

To address this sealing problem, the assignee of the present invention has developed several different low liquidus temperature inorganic materials which can be used to hermetically seal an OLED device (or other types of devices). The low liquidus temperature inorganic materials include a tin-fluorophosphate material, a chalcogenide material, a tellurite material, a borate material and a phosphate material. A detailed discussion of these low liquidus temperature inorganic materials and how they can be deposited onto a device and then heat-treated to hermetically seal the device is provided in U.S. Patent Application Serial No. 11/207,691 filed on August 18, 2005 and entitled "Method for Inhibiting Oxygen and Moisture Degradation of a Device and the Resulting Device" (published as US2007/0040501A1, the contents of which are incorporated herein by reference in its entirety). Although these low liquidus temperature inorganic materials work well to hermetically seal an OLED device (or other types of devices) there is still a desire to develop new and improved sealing materials and sealing techniques which can be used to hermetically seal an OLED device (or other types of devices). These particular needs and other needs have been satisfied by the present invention.

### SUMMARY

The present invention introduces a method for using a Sn²⁺-containing inorganic material to form a hermetic seal on an OLED device (or other types of devices). In one embodiment, a Sn²⁺-containing inorganic material is deposited onto an OLED device (or other type of device) and then sintered/heat-treated independently at a relatively low temperature (e.g., less than 100°C) to form a hermetic thin film barrier layer over the OLED device (or other type of device). The preferred Sn²⁺-containing inorganic material includes, for example, SnO, blended SnO & P₂O₅-containing powders, and blended SnO & BPO₄ powders (note: the deposited SnO material does not necessarily need to be sintered/heat-treated to hermetically seal the device). The hermetic impermeability of the Sn²⁺-containing inorganic materials to steam and oxygen attack has been demonstrated by 1000 hour calcium patch tests in an 85°C, 85% relative humidity environment, thus indicating the suitability of such barrier layers to enable a sealed device to operate at least five years in normal ambient conditions (which means the heat treated Sn²⁺-containing inorganic material has an oxygen permeance of much less than 0.01 cc/m²/atm/day and a water permeance of less than 0.01 g/m2/day).

### BRIEF DESCRIPTION OF THE DRAWINGS

A more complete understanding of the present invention may be had by reference to the following detailed description when taken in conjunction with the accompanying drawings wherein:

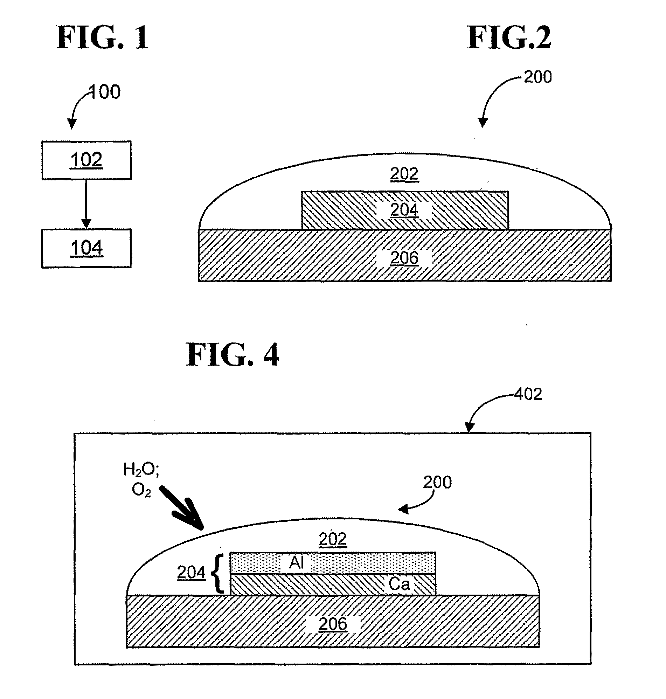

FIGURE 1 is a flowchart illustrating the steps of a method for using a Sn²⁺-containing inorganic material to form a hermetic seal on a device in accordance with the present invention. In FIGURE 1, the reference numerals having the following meanings: 102: Deposit Sn²⁺-containing inorganic material over inner layer(s) located on support (substrate) of device; 104: Heat-treat deposited Sn²⁺ inorganic material at a temperature and environment that does not damage inner layer(s) located on support (substrate) of device.
FIGURE 2 is a cross-sectional side view of a device protected by a Sn²⁺-containing inorganic material in accordance with the present invention;

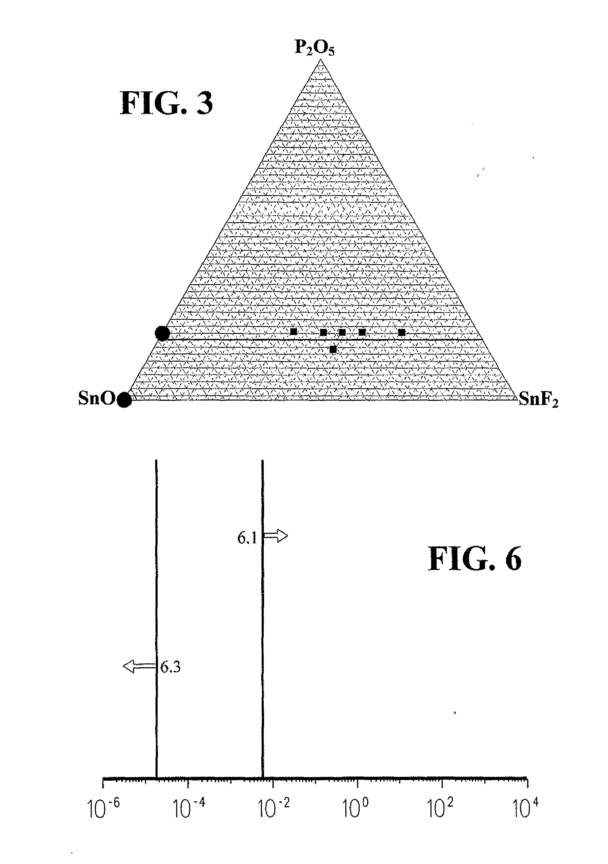

FIGURE 3 is a diagram that graphically illustrates the compositional differences between two exemplary Sn²⁺-containing inorganic materials namely SnO and 80SnO:20P₂O₅ (see black dots) and six exemplary low liquidus temperature (LLT) materials (see black squares);
FIGURE 4 is a diagram of an 85°C/85% humidity accelerated-aging chamber/oven which is provided to help explain the set-up and operation of the various calcium patch tests that were conducted to analyze the performance of thin film barriers made from several different Sn²⁺-containing inorganic materials in accordance with the present invention;

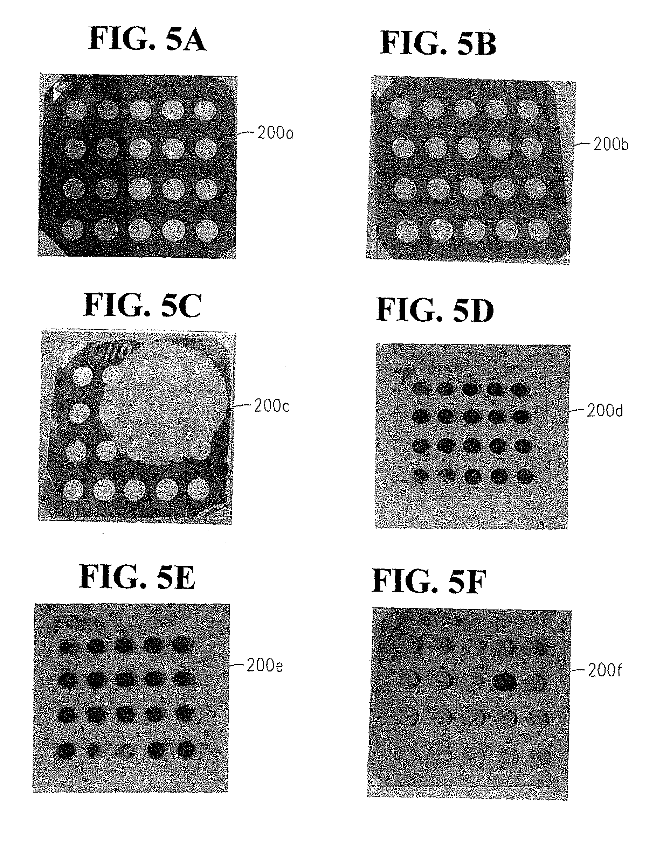

FIGURES 5A-5F are photos of two SnO-coated devices, a SnO₂-coated device (which is not considered part of the present invention), two SnO/P₂O₅-coated devices and a SnO/BPO₄-coated device all of which were prepared and tested to determine how they are able to inhibit oxygen and moisture penetration while in the 85°C/85% humidity accelerated-aging chamber/oven; and
FIGURE 6 is a diagram that graphically illustrates how well the calcium patch test and commercially available MOCON^{™} equipment can measure (or not measure) the moisture barrier performance of a seal on an OLED device. On the horizontal axis of this figure is H₂O permeation rate (g/m2/day at 25°C), 6.1 is limit of MOCON measurement, and 603 is OLED requirements.

### DETAILED DESCRIPTION

As used herein, an inorganic material may be an oxide, a salt, a composite material, and combinations and/or mixtures thereof. An inorganic material represented by, e.g., SnO+P₂O₅, may be a salt and/or oxide having a general formula SnOₓ•(P₂O₅)₁₋ₓ, where x is the molar fraction of SnO in the material. Tep at

Referring to FIGURES 1-2, there are respectively illustrated a flowchart of a method 100 for inhibiting the oxygen and moisture degradation of a device 200 and a cross-sectional side view of the protected device 200 in accordance with the present invention. The method 100 includes step 102 in which a Sn²⁺-containing inorganic material 202 is deposited over one or more inner layers 204 that are located on top of a support/substrate 206 (see FIGURE 2). The Sn²⁺-containing inorganic material 202 can be deposited using any one of variety of processes including, for example, sputtering, flash evaporation, spraying, pouring, frit-deposition, vapor-deposition, dip-coating, painting, rolling (for example a film of Sn²⁺-containing inorganic material 202), spin-coating, a co-evaporation process, a soot gun spraying process, a reactive sputtering process, a laser ablation process, or any combination thereof.

The method 100 also includes step 104 in which the device 200 encapsulated by the deposited Sn²⁺-containing inorganic material 202 is annealed, consolidated or heat-treated (e.g., less than three hours at less than 100°C). The heat treatment step 104 is performed to remove/minimize defects (e.g., pores) within the Sn²⁺-containing inorganic material 202 which may be formed during the deposition step 102 (note: if the Sn²⁺-containing inorganic material 202 is SnO then the sputter-deposition step 102 itself may provide all of the heat necessary for sintering the deposited inorganic material 202). If desired, the deposition step 102 and the heat treatment step 104 can both be performed in an inert atmosphere or in a vacuum to ensure that a water and an oxygen-free condition are maintained throughout the entire sealing process. This type of processing environment is important to help ensure the robust, long-life operation of organic electronics 104 located within the device 200.

Examples of different devices 200 that can be protected by the Sn²⁺-containing inorganic material 202 include a light-emitting device (e.g., OLED device), a photovoltaic device, a thin-film sensor, an evanescent waveguide sensor, a food container and a medicine container. If the device 200 is an OLED device, then the inner layers 204 include cathode and electro-luminescent materials both of which would be located on the substrate 206. The cathode and electro-luminescent materials 204 can be damaged if they are heated above for example 100-125 °C. As such, the heat treatment step 104 would not be possible in this particular application if a traditional material (e.g., soda-lime glass) were deposited on the OLED device 200. Because, the temperature (e.g., 600°C) needed to remove the defects in a traditional material (e.g., soda-lime glass) would be too high and result in severely damaging the OLED device's inner layers 204. However, in the present invention, the heat treatment step 104 can be performed in this particular application because the temperature (e.g., 100°C or less) needed to remove/minimize the defects in the deposited Sn²⁺-containing inorganic material 202 is relatively low so as to not damage the OLED device's inner layers 204. Again, the heat treatment step 104 may not even be required in the first place if for example SnO is the Sn²⁺-containing inorganic material 202 (see FIGURE 5A).

The use of a Sn²⁺-containing inorganic material 202 makes this all possible because this type of material has the ability, when consolidated at relatively low temperatures, to form hermetic encapsulated coatings which protect the device 200. The Sn²⁺-containing inorganic materials 202 differ in several respects from a tin fluorophosphate material which was one of the LLT materials disclosed in the aforementioned U.S. Patent Application Serial No. 11/207,691. First, the Sn²⁺-containing inorganic materials 202 can be heat-treated at a lower temperature than the tin fluorophosphate material (note: the tin fluorophosphate material had been heat treated at ~120°C). Second, the Sn²⁺-containing inorganic materials 202 do not contain fluorine. Thirdly, some of the Sn²⁺-containing inorganic materials 202, such as SnO, have melting temperature in excess of 1000°C, which is greater than the maximum melting temperature of 1000°C associated with the LLT material. Fourthly, the Sn²⁺-containing inorganic materials 202 have different compositions than the tin fluorophosphate materials (e.g., see FIGURE 3 which graphically illustrates the compositional differences between two exemplary Sn²⁺-containing inorganic materials 202 namely SnO and 80SnO:20P₂O₅ (see black dots) and six exemplary tin fluorophosphate materials (see black squares)(note: the co-assigned U.S. Patent Application 11/207,691 discloses and claims these six tin fluorophosphate materials and all of the possible tin fluorophosphate materials shown in FIGURE 3)).

Moreover, the assignee of the present invention has filed another U.S. Patent Application Serial No. 11/509,445 (entitled "TIN PHOSPHATE BARRIER FILM, METHOD, AND APPARATUS") which discloses how low liquidus temperature (LLT) inorganic materials such as a tin phosphate LLT which contains 60 to about 85 mole percent of a tin oxide can be evaporated deposited with a resistive heating element onto a device and then heat-treated to hermetically seal the device. The co-assigned U.S. Patent Application Serial No. 11/509,445 was filed on August 24, 2006 and entitled "Tin Phosphate Barrier Film, Method and Apparatus". The contents of this document are hereby incorporated herein by reference.

The Sn²⁺-containing inorganic materials 202 described herein include compositions such as for example SnO powder, blended SnO/P₂O₅-containing powders, and blended SnO/BPO₄ powders. However, the Sn²⁺-containing inorganic material 202 can also include blended compositions that had been melted to form the appropriate sputtering target (e.g., 80% SnO + 20% P₂O₅). In one embodiment, the Sn²⁺-containing inorganic material 202 contains >50% stannous oxide (and more preferably >70% stannous oxide and even more preferably >80% stannous oxide). Plus, the Sn²⁺-containing inorganic material 202 can be heat treated at <400°C (and preferably <200°C and more preferably <100°C and even more preferably <50°C).

The results of testing four different types of Sn²⁺-containing inorganic materials 202 and conclusions from those experiments are discussed next with respect to TABLE #1 and FIGURES 4-6. TABLE #1 lists the four representative Sn²⁺-containing inorganic materials 202 which were used to test the low temperature sintering behavior which is an important aspect of the present invention.

**TABLE #1**

| **Sn²⁺-containing compound** | **Miscellaneous** | **Rough Descriptor** | **Lowest Tested Sintering Temperature** |
|---|---|---|---|
| SnO* | | Pressed powder*** | Near room temperature (< 40°C) |
| 80% SnO + 20% P₂O₅** | Sn₂P₂O₇ ~ phosphate source | Pressed powder blend | 140°C |
| 80% SnO + 20% P₂O₅** | NH₄H₂PO₄~ phosphate source | Melted target**** | 90°C |
| 90% SnO + 10% BPO₄** | | Pressed powder blend | 140°C |

| | | | |
|---|---|---|---|
| * The SnO is opaque in visible wavelengths. ** The SnO+P₂O₅ and the SnO+BPO₄ are both transparent in visible wavelengths. *** Pressed powder targets were used to deposit many of the films. The pressed powders (Goldschmidt, PA, USA) were batched together to achieve a specific molar ratio (e.g., 100% SnO powder, or 80% SnO + 20% P₂O₅) and just enough isopropanol was added to facilitate compaction into shallow copper dishes (which were machined to fit into a 3" magnetron sputtering gun). Thereafter, a press was used to pack and tightly confine the slurry into the recesses of the copper dishes, which were then placed in a desiccator for storage. **** The melted target refers to a batched powder blend of 80% SnO and 20% P₂O₅ that was heated at 600°C to form a partial melt, which was then poured into a shallow copper dish referred to above, and fitted into a standard 3" sputter gun. | | | |

The candidate Sn²⁺-containing inorganic materials 202 all underwent "calcium patch" tests which were performed to determine how well they could inhibit oxygen and moisture penetration into a device 200. In particular, the calcium patch tests were performed in a 85°C and 85% relative humidity environment for 1000 hours to determine if the Sn²⁺-containing inorganic materials 202 are suitable as hermetic barrier layers for sealing a device 200 (e.g., an OLED display 200 should be able to operate for at least five years in normal ambient conditions). Details about how the calcium patch test was set-up and performed to analyze the different Sn²⁺-containing inorganic materials 202 are discussed next with respect to FIGURE 4.

Referring to FIGURE 4, there is a diagram which is provided to help explain the set-up and operation of several calcium patch tests which were conducted to analyze the performance of the thin film barriers made from several different Sn²⁺-containing inorganic materials 202 in accordance with the present invention. The calcium patch test involved the use of an oven 402 (e.g., 85°C/85% accelerated-aging chamber/oven 402) which contains the tested device 200 that included a deposited Sn²⁺-containing inorganic material 202, two inner layers 204 (Al and Ca) and a substrate 206 (Coming Inc.'s 1737 glass substrate). In this experiment, four devices 200 each encapsulated with a different one of the Sn²⁺-containing inorganic materials 202 were placed within the oven 402 and subjected to environmental aging at a fixed temperature 85°C and 85% relative humidity ("85/85 testing"). In each tested device 200, the Ca layer 204 was initially a highly reflecting metallic mirror. And, if water and oxygen penetrated the top encapsulation layer of the Sn²⁺-containing inorganic material 202, then the metallic Ca 204 would react and turn into an opaque white flaky crust which can be quantified with an optical measurement in order to estimate the amount of time the encapsulated device 200 could theoretically operate in ambient conditions (see FIGURES 5A-5F).

The calcium patch tests were performed as described next on four devices 200 which where encapsulated with four different types of Sn²⁺-containing inorganic materials 202 (note: the calcium patch test was also performed on a device coated with SnO₂ which is a Sn⁴⁺ -containing inorganic material). First, a 100 nm Ca film 204 was evaporated onto a glass (Coming Incorporated's Code 1737) substrate 206. Then, a 150 nm Al layer 204 was evaporated onto the Ca film 204. The Al layer 204 was used to simulate the conditions of a cathode which is typically used to produce in-house polymer light emitting diodes (PLEDs). Using a "dual-boat" customized Cressington evaporator, the 1737 glass substrate 206 was maintained at 130°C and approximately 10⁻⁶ Torr during the Ca and Al evaporation deposition steps. After cooling to room temperature, the vacuum was broken and the calcium patch was extracted and carried in a vacuum dessicator to a RF sputtering vacuum system which was then pumped overnight back to 10⁻⁶ Torr. The tested Sn²⁺-containing inorganic material 202 was then sputtered onto the A1 and Ca layers 204 by an ONYX-3 sputtering gun under relatively gentle RF power deposition conditions (30 W forward/1 W reflected RF power) and low argon pressure (-19 sccm)(see step 102 in FIGURE 1). The sputtering was performed for 3-6 hours to obtain a film thickness in the range of 2-3 µm (chamber pressure ~10⁻³ Torr). The deposition rate was estimated to be in the range of 1 -5Å/second. It should be noted that the Sn²⁺-containing inorganic material 202 can be made as thick as needed depending on the chosen deposition conditions.

Thereafter, three of the created devices 200 were heat-treated at various temperatures (e.g., 90°C-140°C) after deposition and then transferred to a heat block mounted in vacuum which was used to consolidate the sputtered Sn²⁺-containing inorganic material 202 (see step 104 in FIGURE 1). However, one of the created devices 200 which was encapsulated with 100% SnO was not independently heated by resistive heating of the heat block but it did reach room temperature during the sputtering step (note: the heat-treatment step 104 was not performed in this case but there still was a small amount of heat generated during the sputtering step 102). Next, the vacuum was broken and then the heat-treated devices 200 and the non-heat-treated SnO device 200 were all placed in the oven 402 and held at 85°C and 85% relative humidity. During this period, pictures were taken at regular time intervals which were later used to quantify the relative rate of water vapor and oxygen transport if any through the thin film barrier layer 202 on the tested devices 200 (see FIGURES 5A-5F)(note: see aforementioned U.S. Patent Application Serial No. 11/207,691 for a more detailed discussion about the calcium patch test and how to convert the measured permeation rates to a time which is indicative of a device's theoretical operational lifetime in normal ambient conditions).

Referring to FIGURES 5A-5C, there are respectively illustrated photos of the un-annealed SnO-coated device 200a, an annealed SnO-coated device 200b and an annealed SnO₂-coated device 200c (note: this device is not considered part of the present invention because SnO₂ is a Sn⁴⁺-containing inorganic material). The tested devices 200a, 200b and 200c were prepared using sputter-deposited SnO or SnO₂ thin films from SnO or SnO₂ pressed powder targets. These photos illustrate the hermetic behavior of the SnO-coated devices 200a and 200b and the lack of hermetic behavior of the SnO₂-coated device 200c within the 85°C/85% accelerated-aging chamber 402. The un-annealed SnO-coated device 200a was not heated but the temperature of the substrate on which it was attached during the sputter deposition step 102 floated from an initial substrate temperature of 6°C and peaked at 15°C. Thus, the local temperature of the un-annealed SnO-coated device 200a was conservatively estimated to be no more than 40°C and it still survived more than 1000 hours in the 85°C/85% accelerated-aging chamber 402. The annealed SnO-coated device 200b was heated at 140°C for 2 hours in vacuum and it survived more than 1000 hours in the 85°C/85% accelerated-aging chamber 402. And, the annealed SnO₂-coated device 200c was heated at 140°C for 2 hours but the photo illustrates that a failure occurred at less than 50 hours with this barrier layer despite using the same annealing conditions associated with the annealed SnO-coated device 200b (which survived for more than 1000 hours). These results indicate the importance of using divalent tin (Sn²⁺) within the Sn-containing inorganic materials 202. In addition, the annealed SnO₂-coated device 200c experienced substantial delamination (see the large clear circle) while both of the SnO-coated devices 200a and 200b did not, which is another indication of the lack of durability associated with the SnO₂-coated calcium patch 200c.

Referring to FIGURES 5D-5F, there are respectively illustrated photos of a first annealed SnO/P₂O₅-coated device 200d, a second annealed SnO/P₂O₅-coated device 200e and an annealed SnO/BPO₅-coated device 200f. The first annealed SnO/P₂O₅-coated device 200d was prepared with 80%SnO+20%P₂O₅ sputter-deposited pressed-powdered targets and sintered at 140°C for 2 hours and as can be seen exhibited hermetic behavior after 1000 hours within the 85°C/85% accelerated-aging chamber 402 (see TABLE #1 and FIGURE 5D). The second annealed SnO/P₂O₅-coated device 200e was prepared with 80%SnO+20%P₂O₅ sputter-deposited melt target and sintered at 90°C for 2 hours and as can be seen also exhibited hermetic behavior after 1000 hours within the 85°C/85% accelerated-aging chamber 402 (see TABLE #1 and FIGURE 5E). While, the annealed SnO/BO₄-coated device 200e was prepared with 90%SnO+ 10%BPO₄ sputter-deposited pressed-powdered targets and sintered at 140°C for 2 hours and as can be seen also exhibited hermetic behavior after 1000 hours within the 85°C/85% accelerated-aging chamber 402 (see TABLE #1 and FIGURE 5F). These results indicate the successful hermetic behavior of the devices 200 which were encapsulated using the Sn²⁺-containing inorganic material 202 in accordance with the present invention.

The calcium patch test has become a standard screening tool in the industry for characterizing the relative rate of water vapor and oxygen transport through prospective barriers on devices. This type of high sensitivity detection is required since extremely low amounts of moisture and oxygen will destroy OLED devices 200. Moreover, the use of calcium patch testing to determine the barrier layer impermeability to moisture and oxygen is important because recent patents have issued such as U.S. Patent No. 6,720,097 B2 which extol the virtue of their barrier coatings. But, these claims of hermetic behavior are based on measurements obtained by commercial systems, for example MOCON^{™} equipment (PERMATRAN and OXYTRAN systems), which are not sensitive enough to support the claimed hermetic behavior of their particular barriers especially when they are applied to OLED devices. In particular, it is well known that OLED barriers require a moisture barrier performance of <10⁻⁶ water gm/m² per day which is well below the minimum detection limit of MOCON^{™} instruments of 5x10⁻³ g/m²/day in 25-38°C. This particular fact is graphically illustrated in FIGURE 6 and discussed in the following documents:
- Crawford, G.P., ed. Flexible Flat Panel Devices. 2005, Wiley Publishing Ltd.
- Graff, G.L., et al., Barrier Layer Technology for Flexible Devices, in Flexible Flat Panel Devices, G.P. Crawford, Editor. 2005, John Wiley & Sons Ltd: Chichester.
- Burrows, P.E., et al., Gas Permeation and Lifetime Tests on Polymer-Based Barrier Coatings, in SPIE Annual Meeting. 2000, SPIE.

From the foregoing, it can be readily appreciated by those skilled in the art that the present invention utilizes a deposited Sn²⁺-containing inorganic material 202 (e.g., stannous oxide) to form a hermetic barrier layer on a device 200. The Sn²⁺-containing inorganic materials 202 that can be used include, but are not limited to: (a) SnO; (b) SnO + a borate material; (c) SnO + a phosphate material; and/or (d) SnO + a borophosphate material. If desired multiple layers of the same or different types of the Sn²⁺-containing inorganic materials 202 can be deposited on top of the device 200. As discussed above, the Sn²⁺-containing inorganic material(s) 202 are specifically suited for inhibiting oxygen or/and moisture degradation which is a common problem to a wide variety of devices 200 including electronic devices, food or medicine containers. In addition, the Sn²⁺-containing inorganic material(s) 202 may be used to reduce, for example, photochemical, hydrolytic, and oxidative damage due to chemically active permeants. Some additional advantages and features of using the Sn²⁺-containing inorganic material(s) 202 are as follows:
A. The Sn²⁺-containing inorganic material 202 may be used to prepare hermetic thin film (-2 µm) barrier layers that fulfill the most stringent impermeability requirements for OLED long-lived operation (< 10⁻⁶ gm/m² per day water), and may be rapidly sputter-deposited and annealed on devices (or substrate materials) and in some cases at extremely low temperatures (< 40°C). The devices 200 include but are not limited to:
   a. Organic electronic devices
      - Organic light-emitting diodes (OLED)s
      - Organic photovoltaic devices (OPV)s
      - Organic Sensors, with or without catalysts
      - Flexible substrates for flexible flat panel devices
      - Radio frequency identification tags (RFID)s
   b. Semiconductor electronic devices
      - Light-emitting diodes (LED)s
      - Photovoltaic devices (PV)s
      - Sensors, with or without catalysts
      - Flexible substrates for flexible flat panel devices
      - Radio frequency identification tags (RFID)s
   The substrate materials include but are not limited to:
   a. Polymer Materials
      - Flexible substrates for flexible flat panel devices
      - Food packaging
      - Medical packaging
B. The sealing of organic electronic devices 200 with a Sn²⁺-containing inorganic material 202 requires no introduction of oxygen or air into the chamber which contains the freshly deposited coatings when performing the consolidation/heat treatment. The fact that no outside oxidizing source is required to enable the sealing event, especially at low temperatures (~40°C), makes this sealing technique an attractive feature for making organic electronic devices. This is especially true since it is well known that oxygen and moisture are the principal degrading reactants associated with the redox and photo-bleaching degradation reactions which adversely affect the deposited organic layers and/or cathode materials in organic electronic devices like an OLED.
C. Sputter deposition, evaporation, and other thin film deposition processes may be used to deposit Sn²⁺-containing inorganic thin films onto the devices 200. For example, high rate deposition of Sn²⁺-containing inorganic oxide films 202 may be produced by evaporation of metallic tin in an oxygen containing environment on a rolling substrate such as plastic at very high speed. Alternatively, reactive DC sputtering of metallic tin in an oxygen environment may be used to produce the desired high rate deposition of a Sn²⁺-containing inorganic oxide film onto a device 200. In fact, many different thin film deposition techniques may be used to deposit the Sn²⁺-containing inorganic oxide film onto the device 200.
D. The Sn²⁺-containing inorganic material 202 (for example SnO powder) can be batched with different powders/dopants to create a composition designed to achieve a specific physical-chemical property in the deposited barrier layer on the device 200. Following is an exemplary list of various dopants that can be mixed with the Sn²⁺-containing inorganic material 202 to achieve a desired physico-chemical property in the deposited barrier layer:
   a. Opacity-Transparency: SnO is opaque at visible wavelengths, but it may be doped with components such as phosphates to yield transparent films.
   b. Refractive Index: Dopants such as P₂O₅, BPO₄ and PbF₂ can be used alter the film's refractive index to help optimize for instance the light transmission and/or light extraction of the device 200. For example, OLED devices 200 with top emission can be optimized when air gaps are replaced with an index-matched oxide material.
   c. Coefficient of Thermal Expansion (CTE): Dopants such as SnF₂, P₂O₅ and PbF₂can be used to alter the film's CTE to help to minimize different forms of delamination which are commonly associated with "CTE mismatch" problems.
   d. Sensitization: Phosphors, quantum dots, inorganic/organic dyes and molecules may be added to confer desired electro-optic characteristics which are useful for device optimization. For instance, dopants such as carbon black can be used to alter the electro-optic character (Fermi level/resistivity) of the thin barrier coating to improve the device efficiency (note: if the Fermi level can be shifted substantially then this might enable one to alter the conductivity of the barrier film in a manner which is analogous to typical indium-tin-oxide (ITO) systems.
   e. Alter Solubility and Interface Wettability for Better Adhesion: Doping the Sn²⁺-containing inorganic material 202 with materials, such as SnF₂, could enable one to alter the miscibility of the deposited barrier film with organic additives. In fact, this concept may be further exploited to alter the deposited oxide surface wet-ability, for adhesion purposes.
   f. Scratch Resistant: Dopants such as SnO, SnF₂ and PbF₂ may be used to confer a hardness desired for various devices 200.
E. Pattern-Ability: Sputter deposition, or other thin film deposition methods, allow different patterning techniques to be used, such as shadow masking etc., to produce micro-structures having dielectric properties to optimize the operation of the device (e.g., an organic thin film transistor (TFT) device 200 could have insulator gates formed thereon to achieve a good voltage threshold value).

Although several embodiments of the present invention have been illustrated in the accompanying Drawings and described in the foregoing Detailed Description, it should be understood that the invention is not limited to the embodiments disclosed, but is capable of numerous rearrangements, modifications and substitutions without departing from the spirit of the invention as set forth and defined by the following claims.

## Claims

1. A method for inhibiting oxygen and moisture penetration of a device, said method comprising the steps of:
depositing an Sn²⁺-containing inorganic material over at least a portion of said device; and
heat treating said Sn²⁺-containing inorganic material that is deposited over said at least a portion of said device.

2. The method of Claim 1, wherein said depositing step includes utilizing a selected one or a combination of the following:
a sputtering process;
a reactive sputtering process;
a soot gun spraying process; and
a laser ablation process.

3. The method of Claim 1 or claim 2, wherein said heat treating step is performed at a temperature < 200°C.

4. The method of Claim 1 or claim 2, wherein said heat treating step is performed at a temperature < 100°C.

5. The method of Claim 1 or claim 2, wherein said heat treating step is performed at a temperature < 40°C.

6. The method of any one of the preceding claims, wherein said Sn²⁺-containing inorganic material includes stannous oxide.

7. The method of any one of the preceding claims 1-5, wherein said Sn²⁺-containing inorganic material is one of the following, or any combination thereof:
SnO;
SnO and a borate material;
SnO and a phosphate material; and
SnO and a borophosphate material.

8. The method of any one of the preceding claims, wherein said heat treated Sn²⁺-containing inorganic material has an oxygen permeance of less than 0.01 cc/m²/atm/day and a water permeance of less than 0.01 g/m²/day.

9. A device which has at least a portion thereof sealed with a Sn²⁺-containing inorganic material.

10. The device of Claim 9, wherein said Sn²⁺-containing inorganic material includes stannous oxide.

11. The device of Claim 9 or Claim 10, wherein said Sn²⁺-containing inorganic material is one of the following:
SnO;
SnO+P₂O₅; and
SnO+BPO₄.

12. The device of any one of Claims 9 to 11, wherein said Sn²⁺-containing inorganic material is heat-treated at a temperature <100°C, advantageously < 40°C.

13. The device of any one of Claims 9 to 12, which is an organic electronic device comprising:
a substrate plate;
at least one organic electronic or optoelectronic layer; and
a Sn²⁺-containing inorganic material wherein said at least one electronic or
optoelectronic layer is hermetically sealed between said Sn²⁺-containing inorganic material and said substrate plate.

14. The device of Claim 13, comprising:
a substrate plate;
at least one organic light emitting diode; and
a sputtered and non-heat treated SnO film, wherein said at least one organic light emitting diode is hermetically sealed between said sputtered and non-heat treated SnO film and said substrate plate.

15. The device of Claim 14, wherein said sputtered and non-heat treated SnO film has an oxygen permeance of less than 0.01 cc/m²/atm/day and a water permeance of less than 0.01 g/m²/day.
